# EUROPEAN PATENT SPECIFICATION

(11) **EP 2 128 847 B1**
(45) Date of publication and mention of the grant of the patent: **17.11.2010**
(21) Application number: 09157077.0
(22) Date of filing: 01.04.2009
(51) Int. Cl.: G09G 3/32

(54) **Organic light emitting display device**
Organische lichtemittierende Anzeigevorrichtung
Dispositif d'affichage électroluminescent organique

(30) Priority: 13.05.2008 KR 20080043971
(43) Date of publication of application: 02.12.2009
(73) Proprietor: Samsung Mobile Display Co., Ltd., Yongin-City Gyunggi-do (KR)
(72) Inventor: Kwon, Ae-Kyung, Gyeonggi-do (KR); Kim, Se-Ho, Gyeonggi-do (KR)
(74) Representative: Gulde Hengelhaupt Ziebig & Schneider

(56) References cited:
- JP-A- 2000 100 954
- US-A1- 2005 030 214

## Description

### BACKGROUND OF THE INVENTION

### Technical Field of the Invention

The invention relates to an organic light emitting display device, and more particularly to an organic light emitting display device capable of stabilizing the output of a sensor for detecting an external condition.

### Description of the Related Technology

In recent years, various types of flat panel displays have been developed. The flat panel displays are light-weight and small-sized, when compared to cathode ray tubes. Particularly, among the flat panel display devices, the organic light emitting display device is favored with excellent luminance and color purity. The organic light emitting display uses an organic compound as a light emitting material.

An organic light emitting display device is thin and light-weight and may be driven with low power consumption, and therefore it has been expected to be widely used in the field of portable display devices, etc.

However, a portable display device in which the organic light emitting display device is mounted may be exposed to various external environments. Therefore, the organic light emitting display device may have different visibilities according to the external conditions such as the intensity of ambient light, the ambient temperature, etc.

Therefore, it is advisable to adjust the output luminance of the organic light emitting display device according to the external conditions so as to provide visibility that is suitable for the user and prevent excessive light emission of the organic light emitting display.

For this purpose, an external condition detection sensor may be provided in the organic light emitting display device to output a detection signal by sensing the external conditions and control drive circuits according to the detection signal.

However, the output of the external condition detection sensor may be a small current signal. For example, when the external condition detection sensor is composed of a light detection sensor unit to correspond to the intensity of ambient light, a light detection sensor unit may output a light detection signal having a small current value.

Such an output of the external condition detection sensor is easily affected by noise from peripheral circuits or signal lines. Therefore, it is difficult to accurately adjust the output luminance of the organic light emitting display device to a reliable luminance level that corresponds to the external conditions because the output of the external condition detection sensor is unstable.

The United States patent publication US 2005 / 0 030 214 A1 discloses an active matrix OLED display with an ambient light sensor and a temperature sensor connected to the data signal generating circuit. The claims have been characterized with respect to this document.

The Japanese patent publication JP 2000 / 100 954 A (D2) discloses a circuit for preventing cross-coupling noise in the wiring of integrated circuits. In case an aggressor line intersects a victim line, an inverted signal of the aggressor line is generated and fed to a line also crossing the victim line, thereby compensating cross-coupling noise actively.

The Korean patent publications KR-10-2007-0102891 and KR-10-2007-0102893 disclose an ambient light sensor in an LCD, the light sensor comprising a noise cancelling unit and an amplification unit.

The United States patent publication US 2005 / 0 082 968 A discloses a liquid crystal display with an ambient light sensor in the peripheral region at an intersection of a gate line with a read out line.

### SUMMARY OF CERTAIN INVENTIVE ASPECTS

An aspect of the invention provides an organic light emitting display device as set forth in claim 1. Preferred embodiments of the invention are subject matter of the dependent claims.

### BRIEF DESCRIPTION OF THE DRAWINGS

FIG. 1 is a plane view showing an organic light emitting display device according to one exemplary embodiment.

FIG. 2 is a circuit diagram showing a configuration of a sensor output stabilizing unit as shown in FIG. 1.

FIG. 3 is a plane view showing a layout of the sensor output stabilizing unit as shown in FIG. 2.

### DETAILED DESCRIPTION OF CERTAIN INVENTIVE EMBODIMENTS

Hereinafter, certain exemplary embodiments will be described with reference to the accompanying drawings. When a first element is described as being coupled to a second element, the first element may not be directly coupled to the second element but may be indirectly coupled to the second element via a third element. Further, some of the elements that are not essential to the complete understanding of the invention are omitted for clarity. Also, like reference numerals generally refer to like elements throughout.

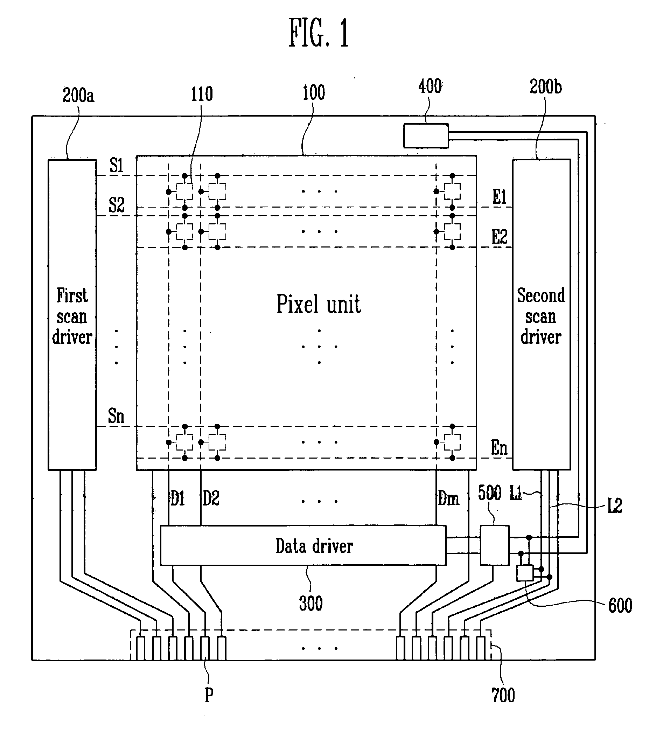

FIG. 1 is a plane view showing an organic light emitting display device according to one exemplary embodiment.

Referring to FIG. 1, the organic light emitting display device includes a pixel unit 100, first and second scan drivers 200a and 200b, a data driver 300, an external condition detection sensor 400, a sensor output amplifier unit 500, a sensor output stabilizing unit 600, and a pad unit 700.

The pixel unit 100 includes a plurality of pixels 110 disposed near intersection points of scan lines (S1 to Sn), light-emitting control lines (E1 to En) and data lines (D1 to Dm). Pixel unit 100 receives a scan signal, a light-emitting control signal and a data signal from the scan lines (S1 to Sn), the light-emitting control lines (E1 to En) and the data lines (D1 to Dm), respectively. Also, the pixel unit 100 further receives first and second pixel power sources (ELVDD and ELVSS) through the pad unit 700. Pixel unit 100 displays an image according to the scan signal, the light-emitting control signal, the data signal, and the first and second pixel power sources (ELVDD and ELVSS).

In this embodiment, the first and second scan drivers 200a and 200b generate a scan signal and a light-emitting control signal according to the scan drive control signal supplied from the pad unit 700.

For example, the first scan driver 200a may receive a start pulse and a clock signal, an output enable signal and the like from the pad unit 700 to generate a scan signal, and generate a scan signal according to the received signals. The scan signal generated in the first scan driver 200a is subsequently supplied to the scan lines (S1 to Sn).

Also, the second scan driver 200b may receive a start pulse, a clock signal and the like from the pad unit 700 to generate a light-emitting control signal, and generate a light-emitting control signal according to the received signals. The light-emitting control signal generated in the second scan driver 200b is subsequently supplied to the light-emitting control lines (E1 to En).

Meanwhile, the two scan drivers 200a and 200b are disposed on either side of the pixel unit 100 to supply a scan signal and a light-emitting control signal to the scan lines (S1 to Sn) and the light-emitting control lines (E1 to En) respectively, as shown in FIG. 1, but the present invention is not limited thereto.

For example, one scan driver may generate both a scan signal and a light-emitting control signal, or may generate only a scan signal without generating a light-emitting control signal. Also, when the scan drivers are provided on both sides of the pixel unit 100, the scan driver provided on one side of the pixel unit 100 may generate some of a scan signal and a light-emitting control signal, and the scan driver provided on the other side of the pixel unit 100 may generate the remainder of the scan signal and light-emitting control signals.

The data driver 300 generates a data signal according to a data drive control signal and data supplied from the pad unit 700. The data signal generated in the data driver 300 is supplied to the data lines (D1 to Dm). In addition, the data driver 300 may be set to control the output luminance of the pixel unit 100 according to a detection signal output from the external condition detection sensor 400. For example, the data driver 300 may control a voltage level of a data signal according to the detection signal in the case of a voltage drive method. Additionally or alternatively, the data driver 300 may control the current of the data signal according to the detection signal, for example, in the case of a current drive method.

The external condition detection sensor 400 senses external condition, and outputs a detection signal corresponding to the external conditions.

For example, the external condition detection sensor 400 may have a light detection device to sense the intensity of ambient light, and output a light detection signal corresponding to the intensity of ambient light. Also, the external condition detection sensor 400 may have a temperature detection device to sense an ambient temperature, and include a temperature detection sensor unit to output a temperature detection signal corresponding to the ambient temperature.

For convenience' sake, this exemplary embodiment is described such that the external condition detection sensor 400 has a light detection sensor unit and a temperature detection sensor unit. In this case, the external condition detection sensor 400 may be designed to output a light detection signal and a temperature detection signal separately.

The sensor output amplifier unit 500 is coupled between the external condition detection sensor 400 and the data driver 300. The sensor output amplifier unit 500 includes an amplifier circuit for amplifying a current value (or, a voltage value) of the detection signals from the external condition detection sensor 400. That is to say, the sensor output amplifier unit 500 amplifies the detection signal supplied from the external condition detection sensor 400 and supplies the amplified detection signal to the data driver 300.

The sensor output stabilizing unit 600 is coupled to an output line of the external condition detection sensor 400. The output stabilizing unit 600 is provided to stabilize the output of the external condition detection sensor 400, because the output line of the external condition detection sensor 400 is in a high-impedance state.

More particularly, the output of the external condition detection sensor 400 may be a small current value (for example, a current value of about 100nA or less). In this case, a separate power source is not connected to the output line of the external condition detection sensor 400, and the output line of the external condition detection sensor 400 is in a high-impedance state when the small electric current is output. In this case, the detection signal may be affected by peripheral circuits or other signal lines.

In particular, the external condition detection sensor 400 and the sensor output amplifier unit 500 may be provided in a panel of the organic light emitting display device in consideration of the unit price. In this case, an output line of the external condition detection sensor 400 may be disposed so that the output line crosses at least some input lines and/or output lines (hereinafter, referred to as input/output lines) of the first and/or second scan drivers 200a and 200b. The input lines of the first and/or second scan drivers 200a and 200b includes lines for supplying a start pulse, a clock signal and/or driver power sources to drive the first and/or second scan drivers 200a and 200b. The output lines of the first and/or second scan drivers 200a and 200b may include lines for outputting a scan signal and/or a light-emitting control signal (for example, a scan signal and/or a light-emitting control signal of the last terminal), which are outputted from the first and/or second scan drivers 200a and 200b, through the pad unit 700, and test the scan signal and/or the light-emitting control signal.

For example, since the first and/or second scan drivers 200a and 200b are disposed on both sides (the left and right sides as shown in FIG. 1) of the panel of the organic light emitting display device, the external condition detection sensor 400 and the sensor output amplifier unit 500 may be provided in upper and/or lower sides, away from the first and second drivers 200a and 200b. Particularly, the external condition detection sensor 400 and the sensor output amplifier unit 500 may be disposed respectively in the upper and lower sides of the panel in consideration of the sizes of the external condition detection sensor 400 and the sensor output amplifier unit 500 and the spaces formed in the upper and lower sides of the panel.

In this case, the sensor output amplifier unit 500 may be disposed on one side of the data driver 300 to reduce a distance to the data driver 300 and to facilitate the measurement of characteristics of an output terminal. For example, the sensor output amplifier units 500 may be disposed in a lower side of the second scan driver 200b, as shown in FIG. 1.

However, the output lines of the external condition detection sensor 400 coupled from the external condition detection sensor 400 to the sensor output amplifier unit 500 may be formed so that the output lines of the external condition detection sensor 400 can cross the input/output lines of the second scan driver 200b. That is to say, parasitic capacitors may be formed between the output lines of the external condition detection sensor 400 and the output lines of the second scan driver 200b. Scan control signals for driving the second scan driver 200b is supplied to the input/output lines of the second scan driver 200b. For example, when the second scan driver 200b generates a light-emitting control signal, a light-emitting control start pulse, a first and second light-emitting control clock signal and an input power of the second scan driver 200b may be input through the input lines of the second scan driver 200b, respectively. A light-emitting control signal output to the last terminal of the second scan driver 200b may be output to the output lines of the second scan driver 200b to test the light-emitting control signal. That is to say, three input/output lines of the second scan driver 200b are shown in FIG. 1 for convenience' sake, but the number of the input/output lines may be widely varied according to the second scan driver 200b.

Similarly, some of the scan control signals and/or light-emitting control signals supplied to the input/output lines of the second scan driver 200b may affect the detection signal output to the output lines of the external condition detection sensor 400, and change the detection signal.

In particular, alternating scan control signals and/or light-emitting control signals whose voltage levels repeatedly change may change the detection signal due to coupling through parasitic capacitors. For example, the start pulse of the light-emitting control signal input to the input line of the second scan driver 200b, and the light-emitting control signal output to the output line of the second scan driver 200b may couple onto the detection signal line.

In order to reduce the effect of the coupling, a sensor output stabilizing unit 600 is connected to some of the input/output lines, of the input/output lines of the second scan driver 200b. The input/output lines are disposed so that they overlap the output line of the external condition detection sensor 400, and the output line of the external condition detection sensor 400. Some of the input/output lines are represented by L1 and L2, as shown in FIG. 1.

Some embodiments of the sensor output stabilizing unit 600 include at least an inverter and a capacitor to compensate for the changes in the voltage level caused by the coupling reaction, and further description thereof will given below.

The pad unit 700 includes a plurality of pads (P) coupled to external drive circuits (not shown). Such a pad unit 700 transmits, for example, driver power sources and/or drive signals, supplied from each of the pads (P), to the panel. For example, the pad unit 700 may supply the driver power sources and/or drive signals, supplied from each of the pads (P), into the pixel unit 100, the first and second scan drivers 200a and 200b, the data driver 300, the external condition detection sensor 400, the sensor output amplifier unit 500 and/or the sensor output stabilizing unit 600.

As described above, the organic light emitting display device of FIG. 1 is configured to compensate for the changes in the detection signal caused by the coupling of the overlapped signal lines by coupling the sensor output stabilizing unit 600 to the output line of the external condition detection sensor 400.

Therefore, an organic light emitting display device that may reliably cope with the changes in the external conditions may be provided because the output of the external condition detection sensor 400 is stable.

Meanwhile, FIG. 1 shows that the sensor output amplifier unit 500 is disposed in a region below the second scan driver 200b, but the present invention is not limited thereto. For example, the sensor output amplifier unit 500 may be disposed in a region below the first scan driver 200a. In this case, the sensor output stabilizing unit 600 may be coupled to some of the input/output lines, of the first scan driver 200a because they overlap the output line of the external condition detection sensor 400.

Also, FIG. 1 shows that the external condition detection sensor 400 controls the data driver 300, but the present invention is not limited thereto. For example, the detection signal output from the external condition detection sensor 400 may be supplied to the first and/or second scan drivers 200a and 200b to control the pulse width of the scan signal and/or the light-emitting control signal that are generated in the first and/or second scan drivers 200a and 200b.

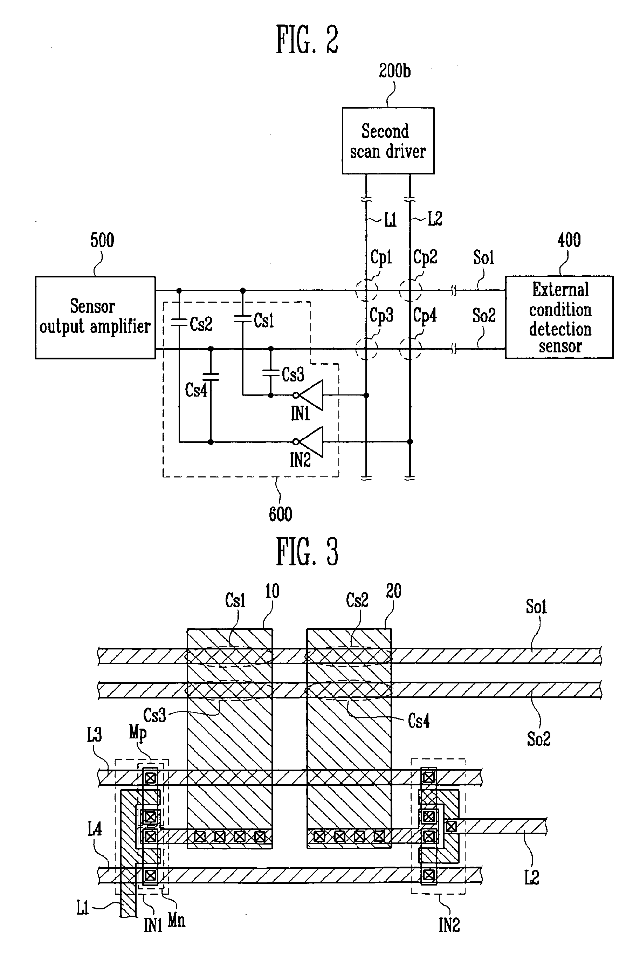

FIG. 2 is a circuit view showing an embodiment of a sensor output stabilizing unit as shown in FIG. 1. FIG. 3 is a plane view showing a layout of the sensor output stabilizing unit as shown in FIG. 2.

In this embodiment, the output lines of the external condition detection sensor 400 are first and second output lines (Sol and So2), shown in FIGS. 2 and 3. In addition, a first detection signal (for example, a light detection signal) and a second detection signal (for example, a temperature detection signal) are output to the first and second output lines (Sol and So2) of the external condition detection sensor 400, respectively. Also, FIGS. 2 and 3 show that some of the input/output lines (L1 and L2) of the second scan driver 200b are disposed so that they cross the first and second output lines (So1 and So2) of the external condition detection sensor 400.. For example, the first input/output line (L1) may, for example, be an input line for supplying a start pulse of a light-emitting control signal from the pad unit 700 to the second scan driver 200b. The second input/output line (L2) may, for example, be an output line for outputting at least one light-emitting control signal from the second scan driver 200b to the pad unit 700. However, this is merely illustrative in this exemplary embodiment for better understanding, and the present invention is not limited thereto.

Referring to FIGS. 2 and 3, the sensor output stabilizing unit 600 includes inverters (IN1 and IN2) and capacitors (Cs1 to Cs4), all of which are coupled between some of the input/output lines (L1 and L2) of the second scan driver 200b crossing the output lines (Sol and So2) of the external condition detection sensor 400. As shown, the inverters (IN1 and IN2) and the capacitors (Cs1 to Cs4) are coupled between the output lines (So1 and So2) of the external condition detection sensor 400, i.e., input ends of the sensor output amplifier unit 500, and some of the input/output lines (L1 and L2) of the second scan driver 200b.

More particularly, the first inverter (IN1) is coupled between the first input/output line (L1) of the second scan driver 200b and the first and second output lines (Sol and So2) of the external condition detection sensor 400. A first capacitor (Cs1) is coupled between the output line of the first inverter (IN1) and the first output line (So1) of the external condition detection sensor 400, and a third capacitor (Cs3) is coupled between the output line of the first inverter (IN1) and the second output line (So2) of the external condition detection sensor 400.

The first inverter (IN1) and the first capacitor (Cs1) compensate for the changes in a first detection signal coupled by the first parasitic capacitor (Cpl) formed between the first input/output line (L1) of the second scan driver 200b and the first output line (So1) of the external condition detection sensor 400. That is to say, although the first detection signal is changed by the coupling of the first parasitic capacitor (Cs1), the change in the first detection signal is at least partially canceled by an inverted signal generated by the first inverter (IN1) and the coupling of the first capacitor (Cs1) to the sensor output amplifier unit 500.

In addition, the first inverter (IN1) and the third capacitor (Cs3) compensate for the changes in the first detection signal coupled by the third parasitic capacitor (Cs3) in the same manner as described above, the third parasitic capacitor (Cs3) being formed between the first input/output line (L1) of the second scan driver 200b and the second output line (So2) of the external condition detection sensor 400.

The second inverter (IN2) is coupled between the second input/output line (L2) of the second scan driver 200b and the first and second output lines (So1 and So2) of the external condition detection sensor 400. The second capacitor (Cs2) is coupled between the output line of the second inverter (IN2) and the first output line (So1) of the external condition detection sensor 400, and the fourth capacitor (Cs4) is coupled between the output line of the second inverter (IN2) and the second output line (So2) of the external condition detection sensor 400.

The second inverter (IN2) and second capacitor (Cs2) compensate for the changes in the second detection signal coupled by the second parasitic capacitor (Cs2) formed between the second input/output line (L2) of the second scan driver 200b and the first output line (So1) of the external condition detection sensor 400. The second inverter (IN2) and the fourth capacitor (Cs4) compensate for the changes in the second detection signal coupled by the fourth parasitic capacitor (Cs4) formed between the second input/output line (L2) of the second scan driver 200b.

The sensor output stabilizing unit 600 as described above may be arranged, for example, as shown in FIG. 3.

More particularly, first to fourth capacitors (Cs1 to Cs4) may be formed using the first and second conductive layers 10 and 20 that are overlapped with the output lines (Sol and So2) of the external condition detection sensor 400. The first conductive layer 10 is coupled to the first inverter (IN1) whose input is coupled to the first input/output line (L1) of the second scan driver 200b. The second conductive layer 20 is coupled to the second inverter (IN2) whose input is coupled to the second input/output line (L2) of the second scan driver 200b. Here, L3 and L4 are supply lines through which first and second reference power sources of the inverters (IN1 and IN2) are supplied, respectively. In the embodiment of FIG. the inverters (IN1 and IN2) each comprise one P-type and one N-type transistors (Mp and Mn), but in other embodiments, each of the inverters (IN1 and IN2) may include a plurality of P-type transistors and N-type transistors.

According to the exemplary embodiments as described above, the sensor output stabilizing unit 600 compensates for the changes in the detection signal outputted from the output lines (Sol and So2) of the external condition detection sensor 400. Therefore, the detection signal may be stably supplied to the sensor output amplifier unit 500.

While the present invention has been described in connection with certain exemplary embodiments, it is to be understood that the invention is not limited to the disclosed embodiments, but, on the contrary, is intended to cover various modifications and equivalent arrangements included within the scope of the appended claims.

## Claims

1. An organic light emitting display device comprising:
a plurality of scan lines (S1...Sn), a plurality of light-emitting control lines (E1...En) in parallel to the plurality of scan lines (S1...Sn), and a plurality of data lines (D1...Dm) intersecting the scan lines (S1...Sn) and the light-emitting control lines (E1...En);
a pixel unit (100) including a plurality of pixels (110) disposed near intersection points of the scan lines (S1...Sn), the light-emitting control lines (E1...En) and the data lines (D1...Dm);
a first scan driver (200a) connected to the scan lines (S1...Sn) and configured to supply scan signals to said scan lines (S1...Sn);
a second scan driver (200b) connected to the light-emitting control lines (E1...En) and to a plurality of input and output , lines (L1, L2), the second scan driver being configured to supply light-emitting control signals to the light-emitting control lines (E1...En);
a data driver (300) configured to supply data signals to the data lines (D1...Dm); and
an external condition detection sensor (400) configured to sense external conditions and to output a detection signal according to the external conditions to one or more output lines of the external condition detection sensor (400);
**characterised by**
the one or more output lines of the external condition detection sensor (400) crossing at least one of the input and output lines (L1, L2) of the second scan driver (200b) thereby forming a parasitic capacitor (Cp1, Cp2, Cp3, Cp4),
wherein the input and output lines (L1, L2) of the second scan driver (200b) each comprise a proximal section between the second scan driver and the parasitic capacitor (Cp1, Cp2, Cp3, Cp4) and a distal section behind the parasitic capacitor (Cp1, Cp2, Cp3, Cp4),
the organic light emitting display device being further
**characterised by**
a sensor output stabilizing unit (600) coupled to the one or more output lines of the external condition detection sensor (400) and the distal section of the at least one of the input and output lines (L1, L2) of the second scan driver (200b)
and comprising:
an inverter (IN1, IN2) having an input connected to the distal section of the one of the input and output lines (L1, L2) of the second scan driver (200b) and an output
connected to a capacitor (Cs1, Cs3, Cs2, Cs4) coupling the output of the inverter (IN1, IN2) to the one or more output lines of the external condition detection sensor (400).

2. The organic light emitting display device according to claim I, further comprising a sensor output amplifier unit (500) coupled between the external condition detection sensor (400) and the data driver (300), wherein the inverter (IN1, IN2) and the capacitor (Cs1, Cs3, Cs2, Cs4) are coupled between an input of the sensor output amplifier unit and the input or output line (L1, L2) of the second scan driver (200b).

3. The organic light emitting display device according to one of the claims 1 or 2, wherein the input or output line (L1, L2) of the second scan driver (200b) is an input line configured to supply an alternating scan drive control signal to the second scan driver (200b).

4. The organic light emitting display device according to claim 3, wherein the input line is an input line configured to supply a start pulse of the light-emitting control signal to the second scan driver (200b).

5. The organic light emitting display device according to one of the claims 1 or 2, wherein the input or output line (L1, L2) of the second scan driver (200b) is an output line configured to output an alternating light-emitting control signal from the second scan driver (200b).

6. The organic light emitting display device according to one of the preceding claims,
wherein the external condition detection sensor (400) comprises a plurality of detection sensor units each having at least one output line, the detection sensor units being configured to sense a respective one of a plurality of different external conditions and to output a corresponding detection signal according to the respective one of the plurality of different external conditions, and
wherein a plurality of inverters (IN1, IN2) and capacitors (Cs1, Cs3, Cs2, Cs4) are formed such that respective ones of the inverters (IN1, IN2) and the capacitors are coupled to each of the output lines.

7. The organic light emitting display device according to claim 6, wherein the external condition detection sensor (400) comprises a light detection sensor unit configured to sense the intensity of ambient light and to output a light detection signal according to the intensity of ambient light.

8. The organic light emitting display device according to one of the claims 6 or 7, wherein the external condition detection sensor (400) comprises a temperature detection sensor unit configured to sense ambient temperature and to output a temperature detection signal according to the ambient temperature.

9. The organic light emitting display device according to one of the preceding claims, wherein the data driver (300) is adapted to modify the data signals provided to the plurality of data lines (Dl...Dm) depending on the detection signal output from the external condition detection sensor (400).

10. The organic light emitting display device according to claim 9, wherein the data driver (300) is adapted to control at least one of a voltage level and a current value of the data signals according to the detection signal.

## Patentansprüche

1. Organische, lichtemittierende Anzeigevorrichtung, umfassend:
eine Vielzahl von Abtastzeilen (S1... Sn), eine Vielzahl von lichtemittierenden Steuerleitungen (E1... En) parallel zu der Vielzahl von Abtastzeilen (S1... Sn) sowie eine Vielzahl von die Abtastzeilen (S1... Sn) und die lichtemittierenden Steuerleitungen (E1... En) schneidenden Datenleitungen (D1... Dm);
eine Pixeleinheit (100) mit einer nahe den Schnittpunkten der Abtastzeilen (S1...Sn), der lichtemittierenden Steuerleitungen (E1...En) und der Datenleitungen (D1... Dm) angeordneten Vielzahl von Pixeln (110);
einem ersten Abtasttreiber (200a), der mit den Abtastzeilen (S1...Sn) verbunden und zum Zuführen von Abtastsignalen an die Abtastzeilen (S1...Sn) ausgestaltet ist;
einem zweiten Abtasttreiber (200b), der mit den lichtemittierenden Steuerleitungen (E1...En) und einer Vielzahl von Eingangs- und Ausgangsleitungen (L1, L2) verbunden ist, wobei der zweite Abtasttreiber zum Zuführen lichtemittierender Steuersignale an die lichtemittierenden Steuerleitungen (E1...En) ausgestaltet ist;
einen Datentreiber (300), der zum Zuführen von Datensignalen an die Datenleitungen (D1...Dm) ausgestaltet ist; und
einen externen Zustandserfassungssensor (400), der zum Erfassen externer Zustände und zur Ausgabe eines Erfassungssignals gemäß den externen Zuständen an eine oder mehrere Ausgangsleitungen des externen Zustandserfassungssensors (400) ausgestaltet ist;
**dadurch gekennzeichnet, dass**
die eine oder mehreren Ausgangsleitungen des externen Zustandserfassungssensor (400) mindestens eine der Eingangs- und Ausgangsleitungen (L1, L2) des zweiten Abtasttreibers (200b) kreuzen, wodurch eine Fremdkapazität (Cp1, Cp2, Cp3, Cp4) gebildet wird,
wobei die Eingangs- und Ausgangsleitungen (L1, L2) des zweiten Abtasttreibers (200b) jeweils einen proximalen Abschnitt zwischen dem zweiten Abtasttreiber und der Fremdkapazität (Cp1, Cp2, Cp3, Cp4) sowie einen distalen Abschnitt hinter der Fremdkapazität (Cp1, Cp2, Cp3, Cp4) aufweisen,
wobei die organische, lichtemittierende Anzeigevorrichtung weiterhin **gekennzeichnet ist durch**
eine Sensorausgangsstabilisierungseinheit (600), die mit der einen oder mehreren Ausgangsleitungen des externen Zustandserfassungssensors (400) und dem distalen Abschnitt der mindestens einen der Eingangs- und Ausgangsleitungen (L1, L2) des zweiten Abtasttreibers (200b) gekoppelt ist,
und umfassend:
einen Wechselrichter (IN1, IN2) mit einem mit dem distalen Abschnitt der einen der Eingangs- und Ausgangsleitungen (L1, L2) des zweiten Abtasttreibers (200b) verbundenen Eingang und einem mit einem Kondensator (Cs1, Cs3, Cs2, Cs4) verbundenen Ausgang, der den Ausgang des Wechselrichters (IN1, IN2) mit der einen oder mehreren Ausgangsleitungen des externen Zustandserfassungssensors (400) koppelt.

2. Organische, lichtemittierende Anzeigevorrichtung nach Anspruch 1,
weiterhin umfassend eine zwischen den externen Zustandserfassungssensors (400) und den Datentreiber (300) geschaltete Sensorausgangsverstärkereinheit (500), wobei der Wechselrichter (IN1, IN2) und der Kondensator (Cs1, Cs3, Cs2, Cs4) zwischen einen Eingang der Sensorausgangsverstärkereinheit und die Eingangs- oder Ausgangsleitung (L1, L2) des zweiten Abtasttreibers (200b) geschaltet sind.

3. Organische, lichtemittierende Anzeigevorrichtung nach einem der Ansprüche 1 oder 2,
wobei die Eingangs- oder Ausgangsleitung (L1, L2) des zweiten Abtasttreibers (200b) eine Eingangsleitung ist, die zum Zuführen eines wechselnden Abtastantriebssteuersignals an den zweiten Abtasttreiber (200b) ausgestaltet ist.

4. Organische, lichtemittierende Anzeigevorrichtung nach Anspruch 3,
wobei die Eingangsleitung eine Eingangsleitung ist, die zum Zuführen eines Startimpulses des lichtemittierenden Steuersignals an den zweiten Abtasttreiber (200b) ausgestaltet ist.

5. Organische, lichtemittierende Anzeigevorrichtung nach einem der Ansprüche 1 oder 2,
wobei die Eingangs- oder Ausgangsleitung (L1, L2) des zweiten Abtasttreiber (200b) eine Ausgangsleitung ist, die zur Ausgabe eines wechselnden lichtemittierenden Steuersignals vom dem zweiten Abtasttreiber (200b) ausgestaltet ist.

6. Organische, lichtemittierende Anzeigevorrichtung nach einem der vorangegangenen Ansprüche,
wobei der externe Zustandserfassungssensor (400) eine Vielzahl von Erfassungssensoreinheiten jeweils mit mindestens einer Ausgangsleitung umfasst, wobei die Erfassungssensoreinheiten zum Erfassen eines entsprechenden einer Vielzahl verschiedener externer Zustände sowie zur Ausgabe eines entsprechenden Erfassungssignals gemäß dem entsprechenden der Vielzahl verschiedener externer Zustände ausgestaltet sind, und
wobei eine Vielzahl von Wechselrichtern (IN1, IN2) und Kondensatoren (Cs1, Cs3, Cs2, Cs4) derart ausgebildet sind, dass entsprechende der Wechselrichter (IN1, IN2) und der Kondensatoren mit jeder der Ausgangsleitungen verbunden werden.

7. Organische, lichtemittierende Anzeigevorrichtung nach Anspruch 6,
wobei der externe Zustandserfassungssensor (400) eine Lichterfassungssensoreinheit umfasst, die zum Erfassen der Intensität von Umgebungslicht sowie zur Ausgabe eines Lichterfassungssignals gemäß der Intensität des Umgebungslichtes ausgestaltet ist.

8. Organische, lichtemittierende Anzeigevorrichtung nach einem der Ansprüche 6 oder 7,
wobei der externe Zustandserfassungssensor (400) eine Temperaturerfassungssensoreinheit umfasst, die zum Erfassen der Umgebungstemperatur sowie zur Ausgabe eines Temperaturerfassungssignals gemäß der Umgebungstemperatur ausgestaltet ist.

9. Organische, lichtemittierende Anzeigevorrichtung nach einem der vorangegangenen Ansprüche,
wobei der Datentreiber (300) zum Modifizieren der an die Vielzahl von Datenleitungen (D1...Dm) gelieferten Datensignale in Abhängigkeit der Erfassungssignalausgabe von dem externen Zustandserfassungssensor (400) ausgebildet ist.

10. Organische, lichtemittierende Anzeigevorrichtung nach Anspruch 9,
wobei der Datentreiber (300) zum Steuern mindestens von einem eines Spannungspegels und eines Stromwertes der Datensignale gemäß dem Erfassungssignal ausgebildet ist.

## Revendications

1. Dispositif d'affichage électroluminescent organique comprenant :
une pluralité de lignes de balayage (S1...Sn), une pluralité de lignes de commande d'émission lumineuse (E1...En) en parallèle à la pluralité de lignes de balayage (S1...Sn), et une pluralité de lignes de données (D1....Dm) coupant les lignes de balayage (S1...Sn) et les lignes de commande d'émission lumineuse (E1...En) ;
une unité à pixels (100) comprenant une pluralité de pixels (110) disposés à proximité des points d'intersection des lignes de balayage (S1...Sn), des lignes de commande d'émission lumineuse (E1...En,) et des lignes de données (D1... Dm) ;
un premier circuit d'attaque de balayage (200a) connecté aux lignes de balayage (S1...Sn) et configuré pour fournir des signaux de balayage auxdites lignes de balayage (S1...Sn) ;
un second circuit d'attaque de balayage (200b) connecté aux lignes de commande d'émission lumineuse (E1...En) et à une pluralité de lignes d'entrée et de sortie (L1, L2), le second circuit d'attaque de balayage étant configuré pour fournir des signaux de commande d'émission lumineuse aux lignes de commande d'émission lumineuse (E1...En);
un circuit d'attaque de données (300) configuré pour fournir des signaux de données aux lignes de données (D1...Dm) ; et
un capteur de détection de conditions extérieures (400) configuré pour détecter des conditions extérieures et pour délivrer un signal de détection en fonction des conditions extérieures à une ou plusieurs ligne(s) de sortie du capteur de détection de conditions extérieures (400) ; **caractérisé par le fait que** la ou les ligne(s) de sortie du capteur de détection de conditions extérieures (400) coupant au moins l'une des lignes d'entrée et de sortie (L1, L2) du second circuit d'attaque de balayage (200b) forme/forment ainsi un condensateur parasite (Cp1, Cp2, Cp3, Cp4),
dans lequel les lignes d'entrée et de sortie (L1, L2) du second circuit d'attaque de balayage (200b) comprennent chacune une section proximale entre le second circuit d'attaque de balayage et le condensateur parasite (Cp1, Cp2, Cp3, Cp4) et une section distale située derrière le condensateur parasite (Cp1, Cp2, Cp3, Cp4),
le dispositif d'affichage électroluminescent organique étant en outre **caractérisé par** : une unité de stabilisation de sortie de capteur (600) reliée à la ou aux ligne(s) de sortie du capteur de détection de conditions extérieures (400) et à la section distale de la ou des ligne(s) d'entrée et de sortie (L1, L2) du second circuit d'attaque de balayage (200b),
et comprenant :
un inverseur (IN1, IN2) ayant une entrée connectée à la section distale de la ou des ligne(s) d'entrée et de sortie (L1, L2) du second circuit d'attaque de balayage (200b) et une sortie connectée à un condensateur (Cs1, Cs3, Cs2, Cs4) reliant la sortie de l'inverseur (IN1, IN2) à la ou aux ligne(s) de sortie du capteur de détection de conditions extérieures (400).

2. Dispositif d'affichage électroluminescent organique selon la revendication 1, comprenant en outre une unité amplificatrice de sortie de capteur (500) reliée entre le capteur de détection de conditions extérieures (400) et le circuit d'attaque de données (300) dans lequel l'inverseur (IN1, IN2) et le condensateur (Cs1, Cs3, Cs2, Cs4) sont reliés entre une entrée de l'unité amplificatrice de sortie de capteur et la ligne d'entrée ou de sortie (L1, L2) du second circuit d'attaque de balayage (200b).

3. Dispositif d'affichage électroluminescent organique selon l'une des revendications 1 ou 2, dans lequel la ligne d'entrée ou de sortie (L1, L2) du second circuit d'attaque de balayage (200b) est une ligne d'entrée configurée pour fournir un signal de commande d'attaque de balayage alternatif au second circuit d'attaque de balayage (200b).

4. Dispositif d'affichage électroluminescent organique selon la revendication 3, dans lequel la ligne d'entrée est une ligne d'entrée configurée pour fournir une impulsion de déclenchement du signal de commande d'émission lumineuse au second circuit d'attaque de balayage (200b).

5. Dispositif d'affichage électroluminescent organique selon l'une des revendications 1 ou 2 du second circuit d'attaque de balayage (200b) est une ligne de sortie configurée pour délivrer un signal de commande d'émission lumineuse alternatif provenant du second circuit d'attaque de balayage (200b).

6. Dispositif d'affichage électroluminescent organique selon l'une des revendications précédentes,
dans lequel le capteur de détection de conditions extérieures (400) comprend une pluralité d'unités à capteurs de détection ayant chacun au moins une ligne de sortie, les unités à capteur de détection étant configurées pour détecter certaines, respectives, d'une pluralité de conditions extérieures différentes et pour délivrer un signal de détection correspondant en fonction de l'une, respective, de la pluralité de conditions extérieures différentes, et
dans lequel une pluralité d'inverseurs (IN1, IN2) et de condensateurs (Cs1, Cs3, Cs2, Cs4) sont formés de façon que certains, respectifs, des inverseurs (IN1, IN2) et des condensateurs soient reliés à chacune des lignes de sortie.

7. Dispositif d'affichage électroluminescent organique selon la revendication 6, dans lequel le capteur de détection de conditions extérieures (400) comprend une unité à capteur de détection de lumière configuré pour détecter l'intensité de la lumière ambiante et pour délivrer un signal de détection de lumière en fonction de l'intensité de la lumière ambiante.

8. Dispositif d'affichage électroluminescent organique selon l'une des revendications 6 ou 7, dans lequel le capteur de détection de conditions extérieures (400) comprend une unité à capteur de détection de température configurée pour détecter une température ambiante et pour délivrer un signal de détection de température en fonction de la température ambiante.

9. Dispositif d'affichage électroluminescent organique selon l'une des revendications précédentes, dans lequel le circuit d'attaque de données (300) est conçu pour modifier les signaux de données fournies à la pluralité de lignes de données (D1...Dm) en fonction du signal de détection délivré par le capteur de détection de conditions extérieures (400).

10. Dispositif d'affichage électroluminescent organique selon la revendication 9, dans lequel le circuit d'attaque de données (300) est conçu pour commander au moins l'une d'un niveau de tension et d'une valeur de courant des signaux de données en fonction du signal de détection.
